# DEMANDE DE BREVET EUROPEEN

(11) **EP 0 838 904 A1**
(43) Date de publication de la demande: **29.04.1998**
(21) Numéro de dépôt: 97203200.7
(22) Date de dépôt: 14.10.1997
(51) Int. Cl.: H03M 1/18, H03G 3/20

(54) **Dispositif de conversion analogique/numérique à caractéristique de transfert programmable**

(30) Priorité: 25.10.1996 FR 9613067
(71) Demandeur: Philips Electronics N.V., 5621 BA Eindhoven (NL)
(72) Inventeur: Belin, Philippe, 75008 Paris (FR); Marie, Hervé, 75008 Paris (FR)
(74) Mandataire: Caron, Jean

(57) **Abrégé**

La présente invention concerne un dispositif de conversion analogique/numérique, destiné à délivrer en sortie un signal numérique Vout[0:7] résultant de la conversion d'une tension analogique d'entrée Vin, et recevant un signal de régulation CRS qui sert à définir la caractéristique de transfert du dispositif par comparaison avec le signal de sortie Vout[0:7].

Selon l'invention, un tel dispositif comporte un module dit de référence (AO, CMP2) qui permet d'ajuster la valeur numérique du signal de sortie Vout[0:7] à une valeur prédéterminée lorsque la tension analogique d'entrée Vin est nulle, et des moyens (Mx, Vact) pour substituer à ladite tension Vin une tension de référence Vref ayant une valeur prédéterminée, lorsque le dispositif se trouve en mode de réglage.

Applications : Tous types de conversions analogique/numérique.

## Description

La présente invention concerne un dispositif de conversion analogique/numérique, muni d'une entrée dite analogique destinée à recevoir une tension analogique d'entrée, d'une entrée destinée à recevoir un signal dit de régulation, et d'une sortie numérique destinée à délivrer un signal numérique résultant de la conversion de la tension analogique d'entrée, comprenant :
- un premier amplificateur muni d'une sortie et d'une première entrée dite de signal reliée à l'entrée analogique, d'une deuxième entrée dite de commande de gain, destinée à recevoir une tension permettant de modifier le gain de l'amplificateur, et reliée à une borne d'alimentation via une capacité de stockage,
- un convertisseur analogique/numérique muni d'une entrée analogique reliée à la sortie de l'amplificateur et d'une sortie constituant la sortie du dispositif,
- un module de régulation muni d'une entrée dite d'autorisation destinée à recevoir un signal d' autorisation et comportant une première source de courant contrôlable reliée à la capacité de stockage permettant de faire varier la tension aux bornes de ladite capacité, et un premier comparateur destiné à effectuer une comparaison entre un signal représentatif de la tension présente à la sortie du premier amplificateur et le signal de régulation, et délivrant, lorsque le signal d'autorisation est à un état actif, un signal de commande de la conduction de la source de courant.

Un tel dispositif est connu du Brevet Européen No.0 271 936 B1, qui décrit un système de contrôle du gain du premier amplificateur, basé sur une identification et un réglage d'un niveau de tension de paliers de référence que présente le signal de sortie dudit amplificateur, paliers qui correspondent à des paliers similaires du signal d'entrée. Le gain de l'amplificateur est ensuite ajusté de manière à ce que le résultat de la conversion analogique/numérique de son signal de sortie ne dépasse pas une certaine valeur, dite valeur numérique maximale. Ce système présente le défaut de ne pouvoir fonctionner qu' avec des signaux présentant des paliers de référence, du type signaux vidéo, qui sont souvent altérés par du bruit électro-magnétique. Les paliers de référence sont alors peu fiables, ce qui compromet le réglage du gain de l'amplificateur. De plus, la conversion analogique/numérique de signaux ne présentant pas de paliers de référence n'est pas possible avec un tel dispositif.

La présente invention a pour but de remédier à ces inconvénients, en proposant un dispositif de conversion analogique/numérique dans lequel le signal analogique d'entrée n'influe pas sur le réglage du gain de l'amplificateur.

Selon l'invention, un tel dispositif est caractérisé en ce qu'il comporte un module dit de référence qui permet d'ajuster la valeur numérique du signal de sortie du convertisseur analogique/numérique à une valeur prédéterminée lorsque la tension présente à l'entrée de signal de l'amplificateur est nulle, et des moyens pour substituer à la tension analogique d'entrée une tension de référence ayant une valeur prédéterminée, lorsque le signal d'autorisation est à l'état actif.

La caractéristique de transfert de ce dispositif, définie comme l'évolution de la valeur numérique du signal de sortie en fonction de la tension analogique d'entrée, est linéaire lorsque le gain de l'amplificateur est fixé. Deux points de fonctionnement de ladite caractéristique suffisent donc à définir le comportement du dispositif. Le module de référence définit intrinsèquement un premier point de fonctionnement, tandis que la valeur du signal de régulation permet d'ajuster la position du deuxième point de fonctionnement de la caractéristique de transfert : lorsque le signal d'autorisation est à l'état actif, le dispositif évolue selon un mode dit de réglage, dans lequel l'amplificateur reçoit sur son entrée de signal la tension de référence, dont la valeur est connue. Le gain de l'amplificateur est déterminé par la tension aux bornes de la capacité de stockage, elle-même réglée de sorte que les signaux que le comparateur reçoit soient égaux. Le choix de la valeur du signal de régulation permet donc un réglage simple du fonctionnement du dispositif, indépendamment de la tension analogique d'entrée.

Un mode de réalisation de l'invention présente un dispositif tel que décrit ci-dessus, caractérisé en ce que, le signal de régulation étant de nature numérique, le premier comparateur est muni d'une première entrée numérique destinée à recevoir ledit signal de régulation et d'une deuxième entrée numérique reliée à la sortie du convertisseur analogique/numérique.

Ce mode de réalisation, dans lequel le signal de régulation peut, par exemple, être stocké dans un registre, permet une reconfiguration aisée du dispositif par reprogrammation du contenu dudit registre.

Le signal qui est comparé au signal de régulation résulte d'une amplification. Une modification de la valeur du signal de régulation risque donc de provoquer des variations importantes sur le gain de l'amplificateur. Il peut être avantageux de prévoir des aménagements permettant un réglage plus fin de la valeur dudit gain.

Selon une variante de l'invention, un dispositif de conversion analogique/numérique tel que décrit plus haut est caractérisé en ce qu'il comporte un module dit de variation muni d'une première entrée de tension destinée à recevoir une tension fixe prédéterminée, d'une deuxième entrée, dite de commande, destinée à recevoir un signal de commande, et d'une sortie destinée à délivrer la tension de référence, qui présente par rapport à la tension fixe une différence de potentiel dont la valeur est déterminée par le signal de commande.

Ce module de variation permet de modifier la valeur de la tension de référence, l'amplitude des variations ainsi obtenues avant amplification pendant le mode de réglage étant de préférence faibles devant la valeur de la tension fixe. Il est ainsi possible d'affiner le réglage de la position du deuxième point de fonctionnement réalisé au moyen du signal de régulation.

Dans un mode de réalisation de cette variante, un dispositif de conversion analogique/numérique tel que décrit ci-dessus est caractérisé en ce que le module de variation comporte une résistance dont une première borne est destinée à recevoir la tension fixe et une deuxième borne, constituant la sortie du module de variation, est reliée à une deuxième source de courant dont le débit de courant est réglable, et un convertisseur numérique/analogique, muni d'une entrée numérique formant l'entrée de commande du module de variation et d'une sortie analogique destinée à délivrer un signal permettant un réglage de la valeur du courant débité par la deuxième source de courant.

Dans ce mode de réalisation, le signal de commande peut être stocké dans un registre, ce qui permet une reconfiguration aisée du dispositif par reprogrammation du contenu dudit registre.

Dans un mode de réalisation avantageux de l'invention, le convertisseur analogique/numérique est muni d'une échelle de résistances destinée à fournir à chaque noeud intermédiaire entre deux résistances une tension utilisée par le convertisseur pour définir un code de référence, tandis que le module de référence comporte :
- un deuxième amplificateur semblable au premier amplificateur, deuxième amplificateur dont l'entrée de signal est destinée à être placée à un potentiel nul et dont l'entrée de commande de gain est destinée à être placée à un potentiel prédéterminé.
- un deuxième comparateur muni d'une sortie, d'une première entrée reliée à la sortie du deuxième amplificateur et d'une deuxième entrée reliée à l'un des noeuds intermédiaires de l'échelle de résistances, et
- une troisième source de courant contrôlable destinée à débiter un courant de polarisation au travers de l'échelle de résistances, courant dont la valeur est déterminée par la valeur de la tension présente à la sortie du deuxième comparateur.

Un tel module de référence définit intrinsèquement, par le biais de la polarisation de l'échelle de référence, le premier point de fonctionnement du dispositif, d'une manière simple et fiable. En effet, le courant de polarisation parcourant l'échelle de résistances est régulé en permanence de sorte qu'à une valeur nulle de la tension d'entrée corresponde une valeur numérique fixée du signal de sortie, déterminée par la position au sein de l'échelle de résistances de celui des noeuds intermédiaires qui est relié au comparateur.

L'invention sera mieux comprise à l'aide de la description suivante d'un exemple de réalisation, faite à titre d'exemple et en regard des dessins annexés, dans lesquels :
- la figure 1 est un schéma fonctionnel partiel d'un dispositif de conversion analogique/numérique selon un mode de réalisation avantageux de l'invention, et
- la figure 2 est une représentation de diverses caractéristiques de transfert correspondant à un tel dispositif.

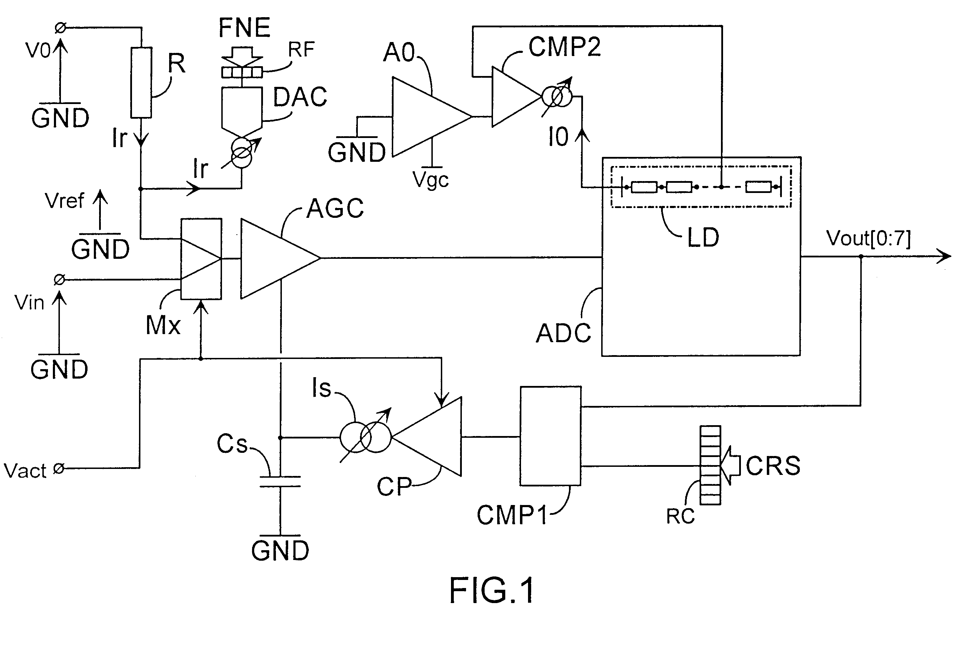

La figure 1 décrit schématiquement un dispositif de conversion analogique/numérique selon un mode de réalisation avantageux de l'invention. Ce dispositif est muni d'une entrée dite analogique destinée à recevoir une tension analogique d'entrée Vin, d'une entrée destinée à recevoir, en provenance d'un premier registre RC, un signal CRS dit de régulation, et d'une sortie numérique destinée à délivrer un signal numérique Vout[0:7] résultant de la conversion de la tension analogique d'entrée Vin. Ce dispositif comprend :
- un premier amplificateur AGC, par exemple construit sur la base d'une cellule de Gilbert, muni d'une sortie et d'une première entrée dite de signal reliée à l'entrée analogique, d'une deuxième entrée dite de commande de gain, destinée à recevoir une tension permettant de modifier le gain de l'amplificateur, et reliée à une borne d'alimentation GND via une capacité de stockage Cs,
- un convertisseur analogique/numérique ADC muni d'une entrée analogique reliée à la sortie de l'amplificateur AGC et d'une sortie, codée sur 8 bits dans cet exemple et constituant la sortie du dispositif, muni d'une échelle de résistances LD fournissant à chaque noeud intermédiaire entre deux résistances une tension utilisée par le convertisseur ADC pour définir un code de référence,
- un module de régulation muni d'une entrée dite d'autorisation destinée à recevoir un signal d'autorisation Vact et comportant une première source de courant contrôlable Is reliée à la capacité de stockage Cs, et permettant de faire varier la tension aux bornes de ladite capacité Cs, et un premier comparateur CMP1 destiné à effectuer une comparaison numérique entre le signal de sortie Vout[0:7] et le signal de régulation CRS, et délivrant à une pompe de charges CP, lorsque le signal d'autorisation Vact est à un état actif, un signal permettant de commander la conduction de la source de courant Is. Ce dispositif comporte en outre un multiplexeur Mx muni d'une sortie reliée à l'entrée de signal du premier amplificateur AGC, d'une première entrée de données recevant une tension de référence Vref ayant une valeur prédéterminée, d'une deuxième entrée de données recevant la tension analogique d'entrée Vin et d'une entrée de sélection recevant le signal d'activation Vact. Ce multiplexeur permet de substituer à la tension analogique d'entrée Vin la tension de référence Vref lorsque le signal d'autorisation Vact est à l'état actif, c'est-à-dire en mode de réglage. Le dispositif comporte de plus un module dit de référence qui permet d'ajuster la valeur numérique du signal de sortie Vout[0:7] du convertisseur ADC à une valeur prédéterminée lorsque la tension présente à l'entrée de signal de l'amplificateur AGC est nulle. Ce module de référence comprend :
- un deuxième amplificateur AO semblable au premier amplificateur AGC, deuxième amplificateur AO dont l'entrée de signal est placée à un potentiel nul et dont l'entrée de commande de gain est placée à un potentiel Vgc prédéterminé,
- un deuxième comparateur CMP2, de nature analogique, muni d'une sortie, d'une première entrée reliée à la sortie du deuxième amplificateur AO et d'une deuxième entrée reliée à l'un des noeuds intermédiaires de l'échelle de résistances LD, et
- une source de courant contrôlable débitant un courant de polarisation IO au travers de l'échelle de résistances LD, courant IO dont la valeur est déterminée par la valeur de la tension présente à la sortie du deuxième comparateur CMP2.

Le dispositif de conversion analogique/numérique représenté ici comprend une résistance R dont une première borne est destinée à recevoir une tension fixe VO et dont une deuxième borne délivre la tension de référence Vref, étant reliée à une source de courant dont le débit de courant Ir est réglable. Le dispositif comprend en outre un convertisseur numérique/analogique DAC, muni d'une entrée numérique recevant en provenance d'un registre RF un signal de commande FNE, et d'une sortie analogique délivrant un signal permettant le réglage de la valeur du courant Ir. Dans cet exemple, l'entrée du convertisseur numérique/analogique DAC est codée sur 4 bits.

Le noeud intermédiaire de l'échelle de résistances LD qui est relié au deuxième comparateur CMP2 est, dans cet exemple, le noeud situé au milieu de l'échelle de résistances. La sortie du convertisseur analogique/numérique ADC étant codée sur 8 bits et pouvant donc présenter 256 valeurs différentes, appelées codes, ce noeud définit donc le code 128. Le potentiel de ce noeud correspond à une valeur nulle en entrée du deuxième amplificateur AO, qui est une réplique de l'amplificateur AGC. Par conséquent, si la tension analogique d'entrée Vin est nulle, le code obtenu en sortie du convertisseur analogique/numérique ADC sera le code 128. Si Vin est négative, le code obtenu en sortie sera inférieur au code 128, et si Vin est positive, le code obtenu en sortie sera supérieur au code 128. Dans ces deux derniers cas, la valeur du code sera fonction de la valeur du gain du premier amplificateur AGC : le signal de régulation CRS peut prendre un certain nombre de valeurs comprises entre une valeur minimale, CRSmin, et une valeur maximale, CRSmax. Pour une même tension de référence Vref, le passage d'une valeur de CRS à une valeur supérieure va produire les effets suivants, lorsque le dispositif se trouve en mode de réglage : la valeur numérique du signal de sortie Vout[0:7] du convertisseur analogique/numérique ADC devenant inférieure à la valeur de CRS, la sortie du comparateur CMP1 agit sur la pompe de charges CP pour que la source de courant Is injecte du courant dans la capacité de stockage Cs, le signal d'autorisation Vact étant actif. La tension aux bornes de la capacité de stockage Cs augmentant, le gain de l'amplificateur AGC augmente jusqu'à ce que les valeurs des signaux Vout[0:7] et CRS deviennent égales, ce qui modifie la caractéristique de transfert du dispositif et redéfinit donc son comportement. Le pas des variations que l'on obtient en changeant les valeurs de CRS, que l'on peut définir par le nombre de codes qui séparent deux codes obtenus pour deux valeurs successives de CRS, en maintenant la tension de référence inchangée, est important. Il est possible de réduire ce pas, et donc d'améliorer la définition de la caractéristique de transfert, en faisant varier la tension de référence Vref, ce qui est réalisé dans cet exemple au moyen du convertisseur numérique/analogique DAC. L'amplitude des variations ainsi obtenues doit rester faible devant la valeur de la tension fixe VO. Le signal de commande FNE peut prendre 16 valeurs différentes depuis 0 jusqu'à 15, et commander ainsi la conduction d'un courant Ir pouvant prendre autant de valeurs différentes. Ce courant Ir circulant dans la résistance R crée aux bornes de celle-ci une chute de tension dont la valeur dépend directement de la valeur numérique du signal de commande FNE. Si cette valeur est 0, le gain obtenu au moyen du module de régulation est inchangé. Si cette valeur est différente de 0, la tension de référence Vref diminue et la valeur numérique du signal de sortie Vout[0:7] diminue. La valeur de CRS étant inchangée dans cet exemple, le comparateur CMP1 commande l'injection d'un courant Is dans la capacité de stockage Cs, augmentant ainsi le gain de l'amplificateur AGC jusqu'à ce que les signaux d'entrée du premier comparateur CMP1 aient des valeurs égales.

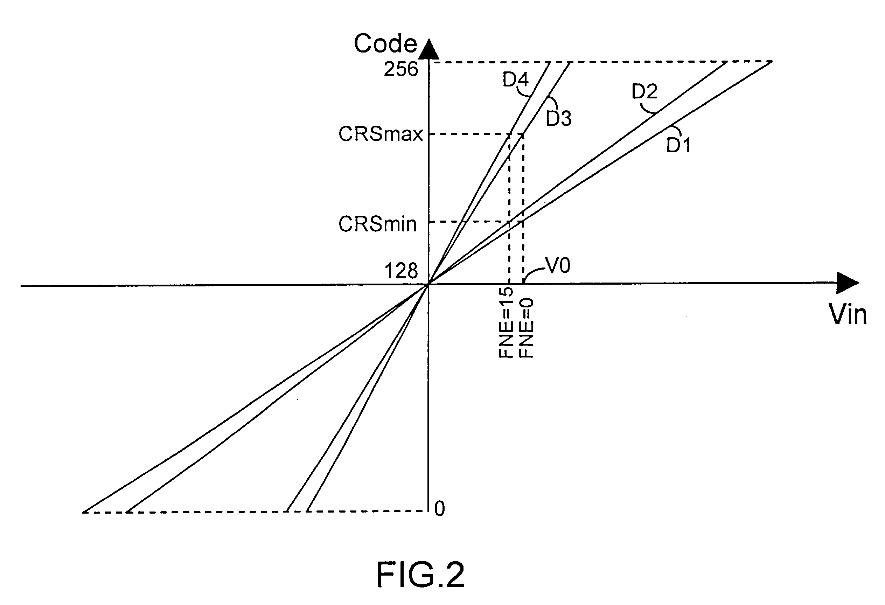

La figure 2 représente diverses caractéristiques de transfert correspondant à un tel dispositif. Le code 128 est fixe et correspond à une tension analogique d'entrée Vin nulle, quelle que soit la valeur du gain du premier amplificateur AGC. Quatre cas extrêmes sont représentés ici : la droite D1 correspond au cas où le signal de régulation CRS est à sa valeur minimale, CRSmin, tandis que la valeur du signal de commande FNE est nulle. Le gain de l'amplificateur AGC est alors à son minimum. La droite D2 correspond au cas où, la valeur de CRS étant toujours CRSmin, la valeur du signal de commande FNE est 15, sa valeur maximale. La surface séparant les droites peut être balayée, par pas fins, en faisant varier la valeur de FNE entre 0 à 15. La droite D3 correspond au cas où le signal de régulation CRS est à sa valeur maximale, CRSmax, tandis que la valeur du signal de commande FNE est nulle. La droite D4 correspond au cas où, la valeur de CRS étant toujours CRSmax, la valeur du signal de commande FNE est 15, sa valeur maximale. Le gain de l'amplificateur AGC est alors à son maximum. La surface séparant ces deux droites peut être balayée, par pas fins, en faisant varier la valeur de FNE entre 0 et 15.

La figure 2 montre par ailleurs qu'il n'est pas nécessaire de coder le signal CRS sur 8 bits pour obtenir des variations significatives de la caractéristique de transfert du dispositif. Ceci permet de réduire la complexité du comparateur CMP1 et donc de diminuer la surface nécessaire à sa réalisation. D'autre part, si dans l'exemple décrit ici, le comparateur CMP1 effectue une comparaison numérique du signal de sortie Vout[0:7] du convertisseur analogique/numérique ADC avec le signal de régulation CRS, dans d'autres modes de réalisation qui ne sortent pas du cadre de l'invention et demeurent à la portée du spécialiste, il est possible de comparer la sortie analogique du premier amplificateur AGC avec un signal de régulation analogique au moyen d'un comparateur CMP1 de nature analogique. De même, si les signaux analogiques traités ici sont des signaux asymétriques, l'homme de l'art connait les modifications mineures à apporter au dispositif afin qu'il traite des signaux symétriques.

## Revendications

1. Dispositif de conversion analogique/numérique, muni d'une entrée dite analogique destinée à recevoir une tension analogique d'entrée, d'une entrée destinée à recevoir un signal dit de régulation, et d'une sortie numérique destinée à délivrer un signal numérique résultant de la conversion de la tension analogique d'entrée, comprenant :
• un premier amplificateur muni d'une sortie et d'une première entrée dite de signal reliée à l'entrée analogique, d'une deuxième entrée dite de commande de gain, destinée à recevoir une tension permettant de modifier le gain de l'amplificateur, et reliée à une borne d'alimentation via une capacité de stockage,
• un convertisseur analogique/numérique muni d'une entrée analogique reliée à la sortie de l'amplificateur et d'une sortie constituant la sortie du dispositif,
• un module de régulation muni d'une entrée dite d'autorisation destinée à recevoir un signal d'autorisation et comportant une première source de courant contrôlable reliée à la capacité de stockage permettant de faire varier la tension aux bornes de ladite capacité, et un premier comparateur destiné à effectuer une comparaison entre un signal représentatif de la tension présente à la sortie du premier amplificateur et le signal de régulation, et délivrant, lorsque le signal d'autorisation est à un état actif, un signal de commande de la conduction de la source de courant,
dispositif caractérisé en ce qu'il comporte un module dit de référence qui permet d'ajuster la valeur numérique du signal de sortie du convertisseur analogique/numérique à une valeur prédéterminée lorsque la tension présente à l'entrée de signal de l'amplificateur est nulle, et des moyens pour substituer à la tension analogique d'entrée une tension de référence ayant une valeur prédéterminée, lorsque le signal d'autorisation est à l'état actif.

2. Dispositif de conversion analogique/numérique selon la revendication 1, caractérisé en ce que, le signal de régulation étant de nature numérique, le premier comparateur est muni d'une première entrée numérique destinée à recevoir ledit signal de régulation et d'une deuxième entrée numérique reliée à la sortie du convertisseur analogique/numérique.

3. Dispositif de conversion analogique/numérique selon l'une des revendications 1 ou 2, caractérisé en ce qu'il comporte un module dit de variation muni d'une première entrée de tension destinée à recevoir une tension fixe prédéterminée, d'une deuxième entrée, dite de commande, destinée à recevoir un signal de commande, et d'une sortie destinée à délivrer la tension de référence, qui présente par rapport à la tension fixe une différence de potentiel dont la valeur est déterminée par le signal de commande.

4. Dispositif de conversion analogique/numérique selon la revendication 3, caractérisé en ce que le module de variation comporte une résistance dont une première borne est destinée à recevoir la tension fixe et une deuxième borne, constituant la sortie du module de variation, est reliée à une deuxième source de courant dont le débit de courant est réglable, et un convertisseur numérique/analogique, muni d'une entrée numérique formant l'entrée de commande du module de variation et d'une sortie analogique destinée à délivrer un signal permettant le réglage de la valeur du courant débité par la deuxième source de courant.

5. Dispositif de conversion analogique/numérique selon l'une quelconque des revendications 1 à 4, caractérisé en ce que, le convertisseur analogique/numérique étant muni d'une échelle de résistances destinée à fournir à chaque noeud intermédiaire entre deux résistances une tension utilisée par le convertisseur pour définir un code de référence, le module de référence comporte :
• un deuxième amplificateur semblable au premier amplificateur, deuxième amplificateur dont l'entrée de signal est destinée à être placée à un potentiel nul et dont l'entrée de commande de gain est destinée à être placée à un potentiel prédéterminé,
• un deuxième comparateur muni d'une sortie, d'une première entrée reliée à la sortie du deuxième amplificateur et d'une deuxième entrée reliée à l'un des noeuds intermédiaires de l'échelle de résistances, et
• une troisième source de courant contrôlable destinée à débiter un courant de polarisation au travers de l'échelle de résistances, courant dont la valeur est déterminée par la valeur de la tension présente à la sortie du deuxième comparateur.
